# EUROPEAN PATENT APPLICATION

(11) **EP 4 135 011 A1**
(43) Date of publication of application: **15.02.2023**
(21) Application number: 21928347.0
(22) Date of filing: 16.09.2021
(51) Int. Cl.: H01L 21/28, H01L 29/51, C23C 16/50, C23C 16/455, C23C 16/44

(54) **THIN FILM DEPOSITION METHOD AND SEMICONDUCTOR DEVICE**

(30) Priority: 02.07.2021 CN 202110753708
(71) Applicant: Changxin Memory Technologies, Inc., Hefei City, Anhui 230000 (CN)
(72) Inventor: YANG, Mengmeng, Anhui 230000 (CN); WANG, Xiaoling, Anhui 230000 (CN)
(74) Representative: Lavoix
(86) International application number: PCT/CN2021/118694
(87) International publication number: WO 2023/272951

(57) **Abstract**

The present application discloses a thin-film deposition method and a semiconductor device. The thin-film deposition method in the present application includes: providing a substrate; performing thin-film deposition on the substrate by using a thin-film deposition technology to form a first deposited layer; introducing a purge gas to perform impurity purge treatment on the first deposited layer to form a purified deposited layer; and forming a thin-film layer by the purified deposited layer. In the thin-film deposition method of the present application, the thin-film deposition technology is adopted to form the deposited layer, and impurity purge treatment is performed on the deposited layer, such that the impurity content of the formed thin-film layer is greatly reduced. The thin-film layer is covered on a surface of a gate to prepare a semiconductor device, such that the gate can be better protected and the service life of the semiconductor device can be remarkably prolonged.

## Description

### Cross-Reference to Related Applications

The present application claims priority to Chinese Patent Application No. 202110753708.4, titled "THIN-FILM DEPOSITION METHOD AND SEMICONDUCTOR DEVICE", filed to China National Intellectual Property Administration on July 02, 2021, which is incorporated herein by reference in its entirety.

### Technical Field

The present application relates to the technical field of semiconductors, and specifically, relates to but is not limited to a thin-film deposition method and a semiconductor device.

### Background

In the prior art, in the manufacturing process of a gate, a thin-film needs to be covered on an upper metal layer of the gate to protect the metal gate. Commonly used thin-film deposition methods include plasma enhanced chemical vapor deposition (PECVD) or plasma enhanced atomic layer deposition (PEALD). The existing thin-film deposition method may introduce impurities in the thin-film deposition process. In addition, after the thin-film deposition, impurity purge treatment is not performed on the thin-film, which seriously affects the service life of the metal gate.

### Summary

The present application provides a thin-film deposition method and a semiconductor device. In the thin-film deposition method, a thin-film deposition technology is adopted to form a deposited layer, and impurity purge treatment is performed on the deposited layer, such that the impurity content of a formed thin-film layer is greatly reduced. The thin-film layer is covered on a surface of a gate to prepare a semiconductor device, such that the gate can be better protected and the service life of the semiconductor device can be remarkably prolonged.

According to a first aspect, the present application provides a thin-film deposition method, including:
step S1: providing a substrate;
step S2: performing thin-film deposition on the substrate by using a thin-film deposition technology, and forming a first deposited layer when the thin-film deposition reaches a first predetermined condition;
step S3: introducing a purge gas to perform impurity purge treatment on the first deposited layer, to form a purified deposited layer;
step S4: repeatedly performing step S2 and step S3 for N times, to form N+1 purified deposited layers, where N is an integer greater than or equal to 0; and
step S5: forming a thin-film layer by the N+1 purified deposited layers.

According to a second aspect, the present application further provides a semiconductor device, including a gate and a thin-film layer disposed on a surface of the gate, where the thin-film layer is formed by using the thin-film deposition method according to the present application.

In the thin-film deposition method provided in the present application, the thin-film deposition technology is adopted to form the deposited layer, and impurity purge treatment is performed on the deposited layer, such that the impurity content of the formed thin-film layer is greatly reduced. The semiconductor device provided in the present application is prepared by covering the thin-film layer according to the present application on the surface of the gate. Because the impurity content of the thin-film layer is low, the gate can be better protected and the service life of the semiconductor device is remarkably prolonged.

### Brief Description of the Drawings

The drawings incorporated into the specification and constituting a part of the specification illustrate the embodiments of the present disclosure, and are used together with the descriptions to explain the principles of the embodiments of the present disclosure. In these accompanying drawings, similar reference numerals are used to represent similar elements. The drawings in the following description are some rather than all of the embodiments of the present disclosure. Persons of ordinary skill in the art may obtain other drawings based on these drawings without creative efforts.
FIG. 1 is a schematic process flowchart of a thin-film deposition method according to an embodiment of the present application;
FIG. 2 to FIG. 7 are each a schematic structural diagram corresponding to a step in a thin-film deposition method according to an embodiment of the present application; and
FIG. 8 to FIG. 11 are each a schematic structural diagram of a semiconductor device according to an embodiment of depositing a thin-film layer according to a thin-film deposition method according to the present application.

### Reference Numerals:

1-substrate, 2-thin-film layer, 210-first deposited layer, 211-purified deposited layer, 212-filling layer, 220-second deposited layer, 3-gate.

### Detailed Description

In order to make the objectives, technical solutions and advantages of the embodiments of the present application clearer, the following clearly and completely describes the technical solutions in the embodiments of the present application with reference to the accompanying drawings in the embodiments of the present application. Apparently, the described embodiments are some rather than all of the embodiments of the present application. All other embodiments obtained by a person skilled in the art based on the embodiments of the present application without creative efforts should fall within the protection scope of the present application. It should be noted that without conflict, the embodiments in the present application and features in the embodiments may be combined with each other.

A thin-film deposition method and a semiconductor device provided in the present application are described in detail below with reference to the accompanying drawings and specific implementations.

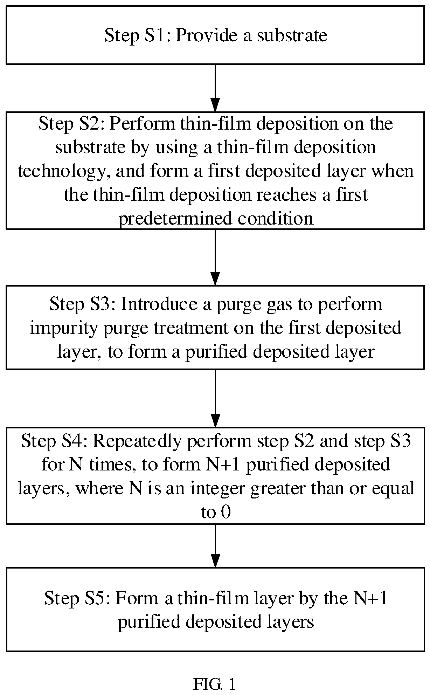

As shown in FIG. 1 to FIG. 7, the thin-film deposition method in this embodiment of the present application includes: Step S1: Provide a substrate 1. Step S2: Perform thin-film deposition on the substrate 1 by using a thin-film deposition technology, and forming a first deposited layer 210 when the thin-film deposition reaches a first predetermined condition. Step S3: Introduce a purge gas to perform impurity purge treatment on the first deposited layer 210, to form a purified deposited layer 211. Step S4: Repeatedly perform step S2 and step S3 for N times, to form N+ 1 purified deposited layers 211, where N is an integer greater than or equal to 0. Step S5: Form a thin-film layer 2 by the N+1 purified deposited layers 211.

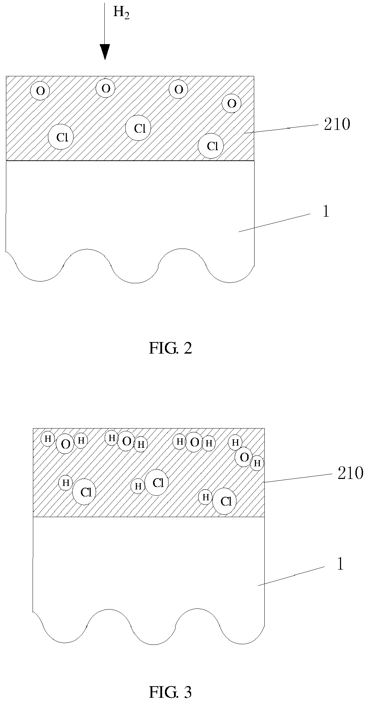

As shown in FIG. 2, step S2 in the thin-film deposition method in this embodiment of the present application is performing thin-film deposition on the substrate 1 by using the thin-film deposition technology, and forming the first deposited layer 210 when the thin-film deposition reaches the first predetermined condition. The thin-film deposition technology used is PECVD or PEALD.

In some embodiments, the thin-film deposition technology used is PECVD or PEALD.

In some embodiments, the first predetermined condition is that a thickness of thin-film deposition is 1/20 to 1/2 of a total thickness of a thin-film layer. In other embodiments, the first predetermined condition is that a number of thin-film deposition cycles is 1/20 to 1/2 of a total number of deposition cycles. Specifically, the first predetermined condition may be that the thickness of thin-film deposition is 1/20, 1/15, 1/10, 1/5, 1/4, 1/3 or 1/2 of the total thickness of the thin-film layer, or the first predetermined condition may be that the number of thin-film deposition cycles is 1/20, 1/15, 1/10, 1/5, 1/4, 1/3 or 1/2 of the total number of deposition cycles.

In some embodiments, the first predetermined condition is that the thickness of thin-film deposition is 1 nm to 20 nm. In other embodiments, the first predetermined condition is that the number of thin-film deposition cycles is 1 to 20.

As shown in FIG. 2 to FIG. 4, step S3 in the thin-film deposition method in this embodiment of the present application includes: introducing the purge gas, where a first gas is produced by a chemical reaction between the purge gas and the impurity in the first deposited layer 210, and the first gas is discharged from the first deposited layer 210, to purge the impurity in the first deposited layer 210 and form the purified deposited layer 211.

In this embodiment of the present application, the substrate includes a substrate and a gate structure formed thereon, the thin-film layer includes a silicon nitride thin-film layer, the impurity includes one or more of a chlorine element, an oxygen element or a hydrogen element, and the purge gas includes hydrogen or ammonia. Specifically, step S3 in the thin-film deposition method includes: introducing a purge gas H₂ into the first deposited layer 210, where a first gas is produced by a chemical reaction between H₂ and the chlorine element or the oxygen element in the first deposited layer 210: the hydrogen chloride and the water vapor, and the hydrogen chloride and the water vapor are discharged from the first deposited layer 210, to purge the chlorine element and the oxygen element in the first deposited layer 210 and form the purified deposited layer 211.

When a traditional thin-film deposition technology is used to form the deposited layer, the deposited layer contains the impurity, which will reduce the stability of the deposited layer, thus reducing the protective effect of the thin-film layer on the substrate and affecting the service life of the substrate. According to the present application, the impurity content of the formed thin-film layer is greatly reduced by performing the impurity purge treatment on the deposited layer, such that the protective effect of the thin-film layer on the substrate is improved and the service life of the substrate is prolonged.

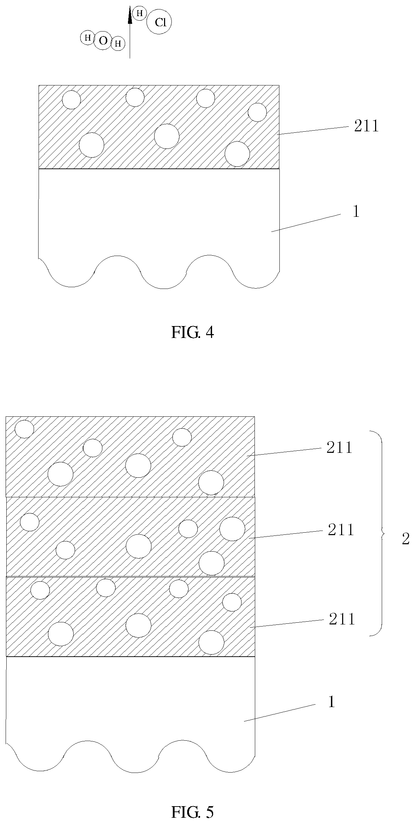

As shown in FIG. 5, step S4 in the thin-film deposition method in this embodiment of the present application is repeatedly performing step S2 and step S3 for N times to form the N+1 purified deposited layers 211, where N is an integer greater than or equal to 0.

In some embodiments, in step S4 in the thin-film deposition method, step S2 and step S3 may not be repeated, and one purified deposited layer 211 is formed; or step S2 and step S3 may be repeated for one or more times, to form two or more purified deposited layers 211. A number of repetition times of step S2 and step S3 is determined based on requirements on the thin-film layer in actual production. If the required thin-film layer is relatively thick or the required total number of deposition cycles is relatively large, the number of repetition times of step S2 and step S3 may be larger. If the required thin-film layer is thin or the required total number of deposition cycles is relatively small, the number of repetition times of step S2 and step S3 may be one or two, or step S2 and step S3 may not be repeated. For example, step S4 in the thin-film deposition method is repeatedly performing step S2 and step S3 twice to form three purified deposited layers 211.

When two or more purified deposited layers 211 are formed, the first predetermined condition for forming each purified deposited layer 211 is independent, and each first predetermined condition is independently that the thickness of thin-film deposition is 1/20 to 1/2 of the total thickness of the thin-film layer or the number of thin-film deposition cycles is 1/20 to 1/2 of the total number of deposition cycles.

The stability of the thin-film layer can be improved by performing the impurity purge treatment on the first deposited layer. When thin-film deposition and impurity purge treatment are repeatedly performed, not only can a thick thin-film layer be formed, but also impurity purge treatment can be performed on each thin-film layer, such that impurities inside the thick thin-film layer can also be purged. This avoids that only impurities on the surface of the thin-film layer or a thinner thin-film are purged, but impurities inside the thick thin-film layer cannot be purged.

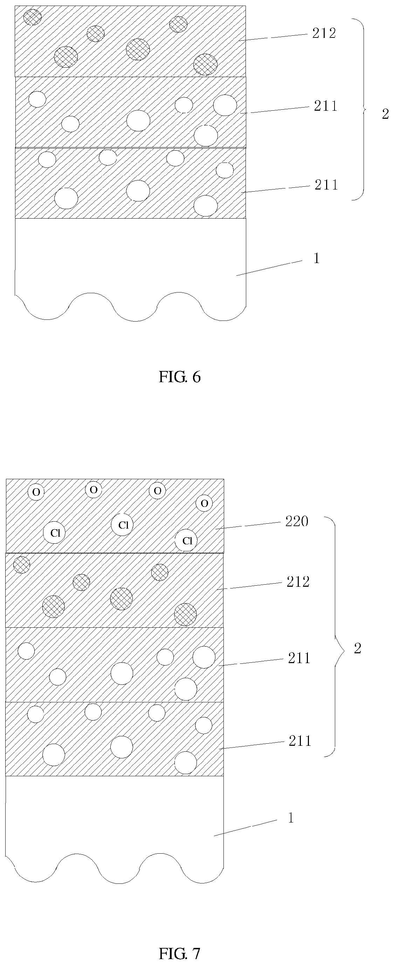

As shown in FIG. 6, after step S4 and before step S5, the thin-film deposition method in this embodiment of the present application further includes: adding a filling material into a formed third purified deposited layer 211 for filling gaps left by purging the impurity in the purified deposited layer 211, to form a filling layer 212, where the formed thin-film layer 2 includes at least one filling layer 212. The filling material includes a nitrogen-containing substance.

In some embodiments, the filling material may be added into any formed purified deposited layer 211 for filling treatment, or the filling material may be added to all the formed purified deposited layers 211 for filling treatment.

In some embodiments, in the thin-film layer formation process, the first formed layer is the filling layer 212, and the last formed layer is the filling layer 212. The formed thin-film layer may include only two filling layers 211. Or the formed thin-film layer may include one or more of the purified deposited layer 211, the second deposited layer 220 and the filling layer 211, between the two filling layers. The presence forms of the purified deposited layer 211, the second deposited layer 220 and the filling layer 211 may be arbitrary, the number of layers may be arbitrary, and the stacking sequence may be arbitrary.

Since the impurity in the first deposited layer is purged by the purge gas, gaps are left in the formed purified deposited layer, and filling the gaps with the filling material to form the filling layer improves the stability of the thin-film layer. When the first layer in the thin-film layer is the filling layer, the stable filling layer can protect the substrate well, for example, the substrate or the gate. When the last layer in the thin-film layer is the filling layer, the impact of external air on the performance of the thin-film layer can be avoided, and the stability of the thin-film layer can be further improved. Therefore, when the first layer and the last layer in the thin-film layer are the filling layer, the thin-film layer can have high stability, such that the thin-film layer can protect the substrate well.

As shown in FIG. 7, step S5 in the thin-film deposition method in this embodiment of the present application includes: performing thin-film deposition on the filling layer 212 by using the thin-film deposition technology, forming a second deposited layer 220 when the thin-film deposition reaches a second predetermined condition, no-performing the impurity purge treatment on the second deposited layer 220, and forming the thin-film layer 2 by the purified deposited layer 211, the filling layer 212 and the second deposited layer 220. The thin-film layer 2 is a silicon nitride thin-film layer.

In other embodiments, after step S1 and before step S2, the thin-film deposition method may further include: performing the thin-film deposition on the substrate 1 by using the thin-film deposition technology, forming a second deposited layer 220 when the thin-film deposition reaches a second predetermined condition, and no-performing the impurity purge treatment on the second deposited layer 220.

In other embodiments, after step S1 and before step S2, the thin-film deposition method may further include: performing thin-film deposition on the substrate 1 by using the thin-film deposition technology, forming a first deposited layer 210 when the thin-film deposition reaches the first predetermined condition, introducing a purge gas to purge an impurity in the formed first deposited layer 210, to form a purified deposited layer 211, and adding a filling material to the formed purified deposited layer 211 for filling treatment, to form a filling layer 212.

In other embodiments, when a plurality of purified deposited layers 211 are formed, between forming any two adjacent purified deposited layers 211, the thin-film deposition method includes: performing the thin-film deposition on a lower purified deposited layer 211 by using the thin-film deposition technology, forming a second deposited layer 220 when the thin-film deposition reaches the second predetermined condition, no-performing the impurity purge on the second deposited layer 220, and then performing thin-film deposition on the second deposited layer 220 to form an upper purified deposited layer 211. That is, the thin-film layer 2 includes the purified deposited layer 211, the second deposited layer 220, and the purified deposited layer 211 that are sequentially stacked.

Before the first purified deposited layer is formed, or after the last purified deposited layer is formed, or between any two adjacent purified deposited layers are formed, thin-film deposition is performed by using the thin-film deposition technology to form the second deposited layer, and impurity purge treatment on the second deposited layer is not performed. The purified deposited layer and the second deposited layer without impurity purge treatment form the thin-film layer together. This can not only improve the stability of the thin-film layer, but also reduce the cost while forming a relatively thick thin-film layer.

In some embodiments, the second predetermined condition is that a thickness of thin-film deposition is 1/20 to 1/2 of a total thickness of the thin-film layer. In other embodiments, the second predetermined condition is that a number of thin-film deposition cycles is 1/20 to 1/2 of a total number of deposition cycles.

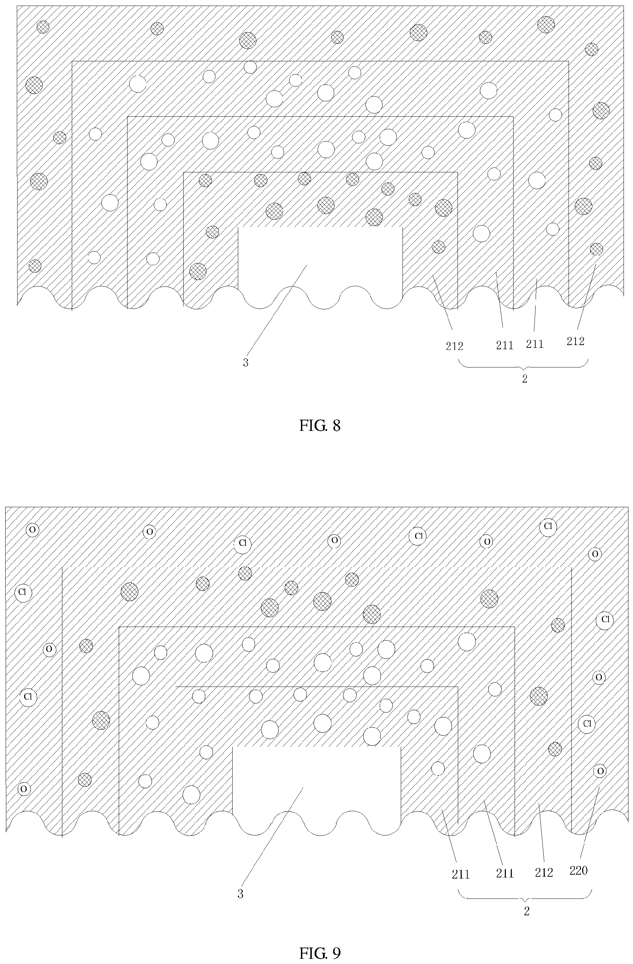

As shown in FIG. 8, a thin-film deposition method in another embodiment of the present application includes: Step S1': Provide a substrate 1. Step S2': Perform thin-film deposition on the substrate 1 by using a thin-film deposition technology, and forming a first deposited layer 210 when the thin-film deposition reaches a first predetermined condition. Step S3': Introduce a purge gas to perform impurity purge treatment on the first deposited layer 210, to form a purified deposited layer 211; and add a filling material into the purified deposited layer 211 for filling treatment, to form a filling layer 212. Step S4': Repeatedly performing step S2' and the impurity purge operation in step S3' for N1 times, to form N1 purified deposited layers 211. Step S5': Perform thin-film deposition on the N1 purified deposited layers 211 to form filling layers 212, where N1 is an integer greater than or equal to 0. For forming the filling layer 212 in step S5', refer to steps S2' and S3'.

A thin-film deposition method in another embodiment of the present application includes: Step S1": Provide a substrate 1. Step S2": Perform thin-film deposition on the substrate 1 by using a thin-film deposition technology, and form a first deposited layer 210 when the thin-film deposition reaches a first predetermined condition. Step S3": Introduce a purge gas to perform impurity purge treatment on the first deposited layer 210, to form a purified deposited layer 211; and add a filling material into the formed purified deposited layer 211 for filling treatment, to form a filling layer 212. Step S4": Repeatedly perform step S2" and the impurity purge operation in step S3" for N2 times, to form N2 purified deposited layers 211. Step S5": Perform thin-film deposition by using the thin-film deposition technology, form a second deposited layer 220 when the thin-film deposition reaches a second predetermined condition; perform thin-film deposition on the second deposited layer 220 to form N3 purified deposited layers 211, and perform thin-film deposition on the N3 purified deposited layers 211 to form a filling layer 212, where N2 and N3 are each an integer greater than or equal to 0. For forming the N3 purified deposited layers 211 and the filling layer 212 in step S5", refer to steps S2" and S3".

As shown in FIG. 8, a semiconductor device according to an embodiment of the present application includes a gate 3 and a thin-film layer 2 disposed on a surface of the gate 3, where the thin-film layer 2 is formed according to the thin-film deposition method in the present application. The thin-film layer 2 includes a first filling layer 212, a first purified deposited layer 211, a second purified deposited layer 211, and a second filling layer 212 that are stacked on the surface of the gate 3 from inside to outside. Impurity purge treatment is performed on the purified deposited layer 211, and the filling layer 212 is formed by filling a nitrogen-containing substance into the purified deposited layer 211.

As shown in FIG. 9, a semiconductor device according to another embodiment of the present application includes a gate 3 and a thin-film layer 2 disposed on a surface of the gate 3. The thin-film layer 2 includes a first purified deposited layer 211, a second purified deposited layer 211, a filling layer 212, and a second deposited layer 220 that are stacked on the surface of the gate 3 from inside to outside. Impurity purge treatment is not performed on the second deposited layer 220.

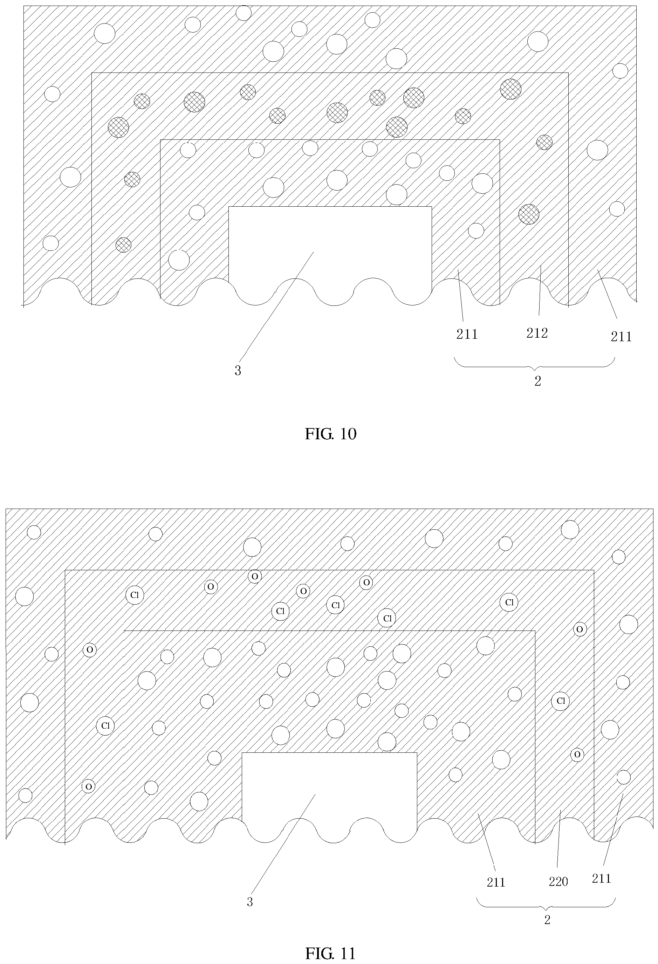

As shown in FIG. 10, a semiconductor device according to another embodiment of the present application includes a gate 3 and a thin-film layer 2 disposed on a surface of the gate 3. The thin-film layer 2 includes a purified deposited layer 211, a filling layer 212, and a purified deposited layer 211 that are stacked on the surface of the gate 3 from inside to outside.

As shown in FIG. 11, a semiconductor device according to another embodiment of the present application includes a gate 3 and a thin-film layer 2 disposed on a surface of the gate 3. The thin-film layer 2 includes a purified deposited layer 211, a second deposited layer 220, and a purified deposited layer 211 that are stacked on the surface of the gate 3 from inside to outside.

In some embodiments, a thickness of the thin-film layer 2 is 1 nm to 50 nm, and a ratio of a total thickness of the purified deposited layer 211 to a total thickness of the second deposited layer 220 is 1: 1 to 10: 1. When the thin-film layer 2 includes the filling layer 212, the total thickness of the purified deposited layer 211 may include a thickness of the filling layer 212. Specifically, the thickness of the thin-film layer 2 may be 1 nm, 5 nm, 10 nm, 20 nm, 25 nm, 30 nm, 40 nm or 50 nm, and a ratio of a total thickness of the purified deposited layer 211 and the filling layer 212 to a total thickness of the second deposited layer 220 is 1: 1, 2: 1, 3: 1, 5: 1, 6: 1, 8: 1 or 10: 1.

It should be noted that relational terms herein such as upper, lower, inside, outside, front, behind, in the middle of, first and second are only used to distinguish one entity or operation from another entity or operation without necessarily requiring or implying any actual such relationship or order between such entities or operations. It should be noted that terms "including", "comprising", or any other variants thereof are intended to cover non-exclusive inclusion, such that a process, method, article, or device including a series of elements includes not only those elements but also other elements not explicitly listed, or elements inherent to such a process, method, article, or device. Without more restrictions, the elements defined by the sentence "including a ..." do not exclude the existence of other identical elements in a process, method, article, or device including the elements.

At last, it should be noted that the above embodiments are only used for describing the technical solutions of the present application, and are not intended to limit the present application. Although the present application is described in detail with reference to the foregoing examples, those of ordinary skill in the art should understand that they can still modify the technical solutions described in the foregoing examples, or make substitutions on some technical features therein. These modifications or substitutions do not make the essence of the corresponding technical solutions deviate from the scope of the technical solutions of the examples of the present disclosure.

It should be noted that, the present application is not limited to the precise structures that have been described above and shown in the accompanying drawings, and can be modified and changed in many ways without departing from the scope of the present disclosure. The scope of the present application is defined by the appended claims.

### Industrial Applicability

In the thin-film deposition method provided in the present application, the thin-film deposition technology is adopted to form the deposited layer, and impurity purge treatment is performed on the deposited layer, such that the impurity content of the formed thin-film layer is greatly reduced. The semiconductor device provided in the present application is prepared by covering the thin-film layer according to the present application on the surface of the gate. Because the impurity content of the thin-film layer is low, the gate can be better protected and the service life of the semiconductor device is remarkably prolonged.

## Claims

1. A thin-film deposition method, comprising:
step S1: providing a substrate;
step S2: performing thin-film deposition on the substrate by using a thin-film deposition technology, and forming a first deposited layer when the thin-film deposition reaches a first predetermined condition;
step S3: introducing a purge gas to perform impurity purge treatment on the first deposited layer, to form a purified deposited layer;
step S4: repeatedly performing step S2 to step S3 for N times, to form N+1 purified deposited layers, wherein N is an integer greater than or equal to 0; and
step S5: forming a thin-film layer by the N+1 purified deposited layers.

2. The thin-film deposition method according to claim 1, further comprising: adding a filling material to at least one formed purified deposited layer for filling gaps left by purging the impurity in the purified deposited layer, to form a filling layer, wherein the formed thin-film layer comprises at least one filling layer.

3. The thin-film deposition method according to claim 2, wherein the filling material comprises a nitrogen-containing substance.

4. The thin-film deposition method according to claim 1, wherein after step S1 and before step S2, or after step S4 and before step S5, the thin-film deposition method further comprises: performing the thin-film deposition by using the thin-film deposition technology, forming a second deposited layer when the thin-film deposition reaches a second predetermined condition, and no-performing the impurity purge treatment on the second deposited layer.

5. The thin-film deposition method according to claim 1, wherein when N is a positive integer greater than or equal to 1, a plurality of purified deposited layers are formed; and between forming any two adjacent purified deposited layers, the thin-film deposition method further comprises: performing the thin-film deposition by using the thin-film deposition technology, forming a second deposited layer when the thin-film deposition reaches a second predetermined condition, and no-performing the impurity purge treatment on the second deposited layer.

6. The thin-film deposition method according to claim 1, wherein the thin-film deposition technology in step S2 is plasma enhanced chemical vapor deposition or plasma enhanced atomic layer deposition.

7. The thin-film deposition method according to claim 1, wherein the first predetermined condition in step S2 is that a thickness of thin-film deposition is 1/20 to 1/2 of a total thickness of the thin-film layer, or a number of thin-film deposition cycles is 1/20 to 1/2 of a total number of deposition cycles.

8. The thin-film deposition method according to claim 1, wherein when the N+1 purified deposited layers are formed, the first predetermined condition for forming each purified deposited layer is independent, and each first predetermined condition is independently that a thickness of thin-film deposition is 1/20 to 1/2 of a total thickness of the thin-film layer, or a number of thin-film deposition cycles is 1/20 to 1/2 of a total number of deposition cycles.

9. The thin-film deposition method according to claim 4 or 5, wherein the second predetermined condition is that a thickness of thin-film deposition is 1/20 to 1/2 of a total thickness of the thin-film layer, or a number of thin-film deposition cycles is 1/20 to 1/2 of a total number of deposition cycles.

10. The thin-film deposition method according to claim 1, wherein the purge gas in step S3 comprises hydrogen or ammonia.

11. The thin-film deposition method according to claim 1, wherein the thin-film layer comprises a silicon nitride thin-film layer, and the impurity comprises one or more of a chlorine element, an oxygen element or a hydrogen element.

12. The thin-film deposition method according to claim 1, wherein step S3 comprises: when the thin-film deposition reaches the first predetermined condition, forming the first deposited layer, and introducing the purge gas into the first deposited layer, wherein a first gas is produced by a chemical reaction between the purge gas and the impurity in the first deposited layer, and the first gas is discharged from the first deposited layer, to purge the impurity in the first deposited layer.

13. The thin-film deposition method according to claim 12, wherein the first gas is one or two of water vapor or hydrogen chloride.

14. A semiconductor device, comprising a gate and a thin-film layer disposed on a surface of the gate, wherein the thin-film layer is formed by using the thin-film deposition method according to claim 1.

15. The semiconductor device according to claim 14, wherein the thin-film layer comprises a filling layer formed by filling a purified deposited layer with a nitrogen-containing substance.

16. The semiconductor device according to claim 14, wherein the thin-film layer further comprises a second deposited layer, and the second deposited layer is not performed the impurity purge treatment.

17. The semiconductor device according to claim 16, wherein the thin-film layer comprises the second deposited layer and the purified deposited layer, the second deposited layer and the purified deposited layer are stacked on the surface of the gate from inside to outside; or the thin-film layer comprises the purified deposited layer and the second deposited layer, the purified deposited layer and the second deposited layer are stacked on the surface of the gate from inside to outside; or the thin-film layer comprises the purified deposited layer, the second deposited layer, and the purified deposited layer, the purified deposited layer, the second deposited layer, and the purified deposited layer are stacked on the surface of the gate from inside to outside.

18. The semiconductor device according to claim 14, wherein a thickness of the thin-film layer is 1 nm to 50 nm, the first predetermined condition is that a thickness of thin-film deposition is 1 nm to 20 nm or a number of thin-film deposition cycles is 1 to 20.

19. The semiconductor device according to claim 16, wherein a ratio of a total thickness of the purified deposited layer to a total thickness of the second deposited layer is 1: 1 to 10: 1.
